Europäisches Patentamt

European Patent Office

Office européen des brevets

(19)

(11) **EP 1 475 664 A2**

(12) **EUROPEAN PATENT APPLICATION**

(43) Date of publication:
**10.11.2004 Bulletin 2004/46**

(51) Int Cl.$^7$: **G03F 1/16**

(21) Application number: **04010574.4**

(22) Date of filing: **04.05.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **08.05.2003 JP 2003130808**

(71) Applicant: **SONY CORPORATION**
**Tokyo (JP)**

(72) Inventors:
• **Yoshizawa, Masaki**
  **Shinagawa-ku Tokyo (JP)**
• **Omori, Shinji**
  **Shinagawa-ku Tokyo (JP)**

(74) Representative: **Müller - Hoffmann & Partner Patentanwälte,**
**Innere Wiener Strasse 17**
**81667 München (DE)**

(54) **Mask, mask blank, and methods of producing these**

(57)     A mask decreased in warping and having a high positioning precision, provided with at least a substrate aperture formed at a portion of a silicon substrate, a first silicon oxide film formed at one surface of the silicon substrate, a single crystal silicon layer formed on the first silicon layer and the substrate aperture, at least one aperture formed at a portion of the single crystal silicon layer on the substrate aperture and passing an exposure beam, a stress controlling layer formed on another surface of the silicon substrate having internal stress for flattening warping of the silicon substrate due to at least compressive stress of the first silicon oxide film; a method of producing the same, a mask blank decreased in warping, and a method of producing the same.

FIG. 2

EP 1 475 664 A2

**Description**

BACKGROUND OF THE INVENTION

1. Field of the Invention

The present invention relates to a mask for lithography, a method of producing the same, a mask blank used for producing a mask, and a method of producing the same.

2. Description of the Related Art

Stencil masks used for low energy electron-beam proximity projection lithography (LEEPL), electron beam projection lithography (EPL), and ion beam projection lithography (IPL) are frequently formed by a silicon-on-insulator wafer or a semiconductor-on-insulator wafer (SOI substrate).

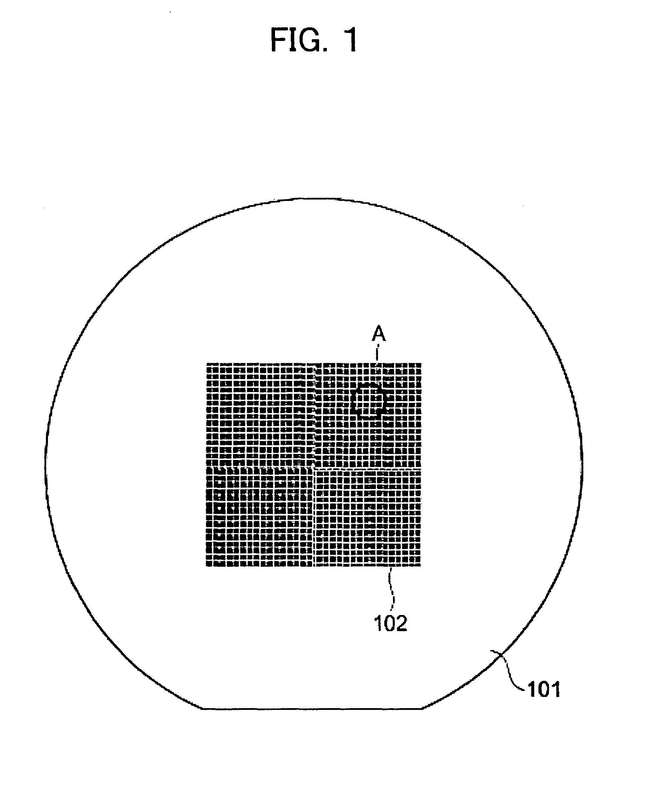

FIG. 1 is a plane view of an example of a stencil mask used for the electron beam projection lithography. As shown in FIG. 1, generally a stencil mask is formed using a silicon substrate 101 having a diameter of 4 to 8 inches (100 mm to 200 mm). The silicon substrate 101 is formed with substrate apertures 102. The substrate apertures 102 are formed over them with a thin film (membrane) having a thickness of about 100 nm to 10 $\mu$m. In FIG. 1, the square portions or rectangular portions shown in black correspond to the substrate apertures 102. The membrane is formed with apertures corresponding to device circuit patterns.

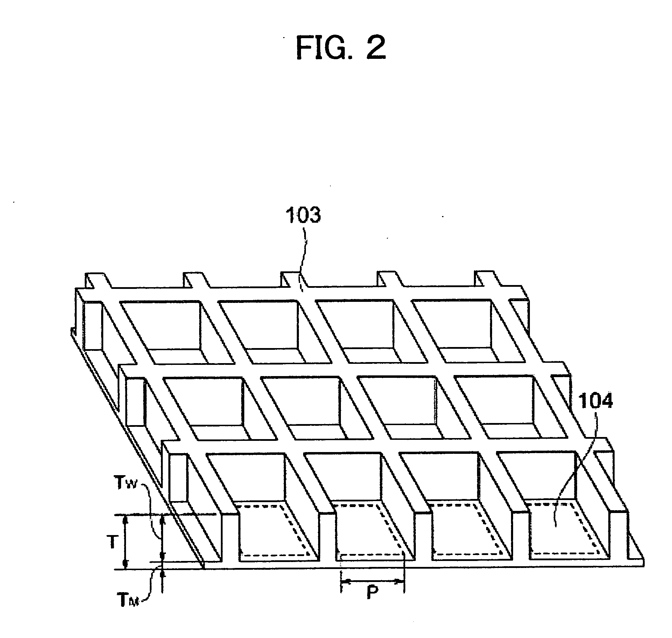

FIG. 2 is a perspective view enlarging portion of FIG. 1 (near the portion shown in A). Struts 103 are formed by the portions remaining after etching the silicon substrate 101 shown in FIG. 1. The thickness T of the mask is the sum of a thickness $T_w$ of the silicon substrate 101 and a thickness $T_M$ of the membrane 104. The membrane 104 is irradiated with an electron beam at the side formed with the struts 103.

The exposed wafer is arranged facing the reverse side of the stencil mask to the surface formed with the struts 103, that is, the membrane 104, and substantially in parallel to the membrane 104. The electron beam passing through the apertures formed in the membrane 104 exposes the resist formed on the wafer to transfer the patterns of the apertures. The portions near the struts 103 in the membrane 104 are blocked from the electron beam by the struts 103. Therefore, apertures corresponding to the patterns are formed at portions other than near the struts 103 (portions P surrounded by broken lines in FIG. 2).

The above structure is formed by growing on the silicon substrate a layer for forming the membrane, generally single crystal silicon, silicon carbide (SiC), silicon nitride (SiN), diamond like carbon (DLC), or diamond, then deeply etching the regions corresponding to membrane at the reverse surface of the silicon substrate, that is, the regions for forming the substrate apertures. For use as a stencil mask, from the viewpoint of flatness and the number of defects, the layer for forming the membrane is required to have an extremely strict quality.

On the other hand, originally the SOI substrate was developed for producing high speed and lower power consumption devices. It was not intended to produce stencil masks. However, an SOI substrate has_a three-layered structure of a thin film SOI layer, a buried oxide film (BOX layer), and a silicon substrate and is controlled to an extremely high uniformity of thickness and quality of the SOI layer corresponding to the membrane region. Due to this, an SOI substrate is suitable for use for a mask blank.

Further, usually the etching selectivity ratio between silicon oxide and silicon is no less than 1000 in dry etching, so the intermediate BOX layer functions as an etching prevention layer when etching the reverse surface of the silicon substrate. Here, since the BOX layer is formed at one surface of the silicon substrate, the "reverse surface" of the silicon substrate means another surface, that is, the exposed surface of the silicon substrate. From this, it is understood that an SOI substrate has the possibility of producing a high quality stencil mask without using sophisticated film-forming technology.

The usual methods of producing an SOI substrate will be described next. There are four types of methods of producing an SOI substrate: (1) bonding method, (2) hydrogen ion implantation and peeling method, (3) epitaxial method, and (4) oxygen ion implantation method. The method (1) is the most basic method of production. However, it has the problems that it is difficult to make the SOI substrate thinner and the uniformity of the thickness is not that good, so the method (1) is generally not used for producing stencil masks. The methods (2) to (4) were developed for obtaining a higher quality SOI layer. Hereinafter, the methods (1) to (4) will be successively explained.

(1) Bonding Method

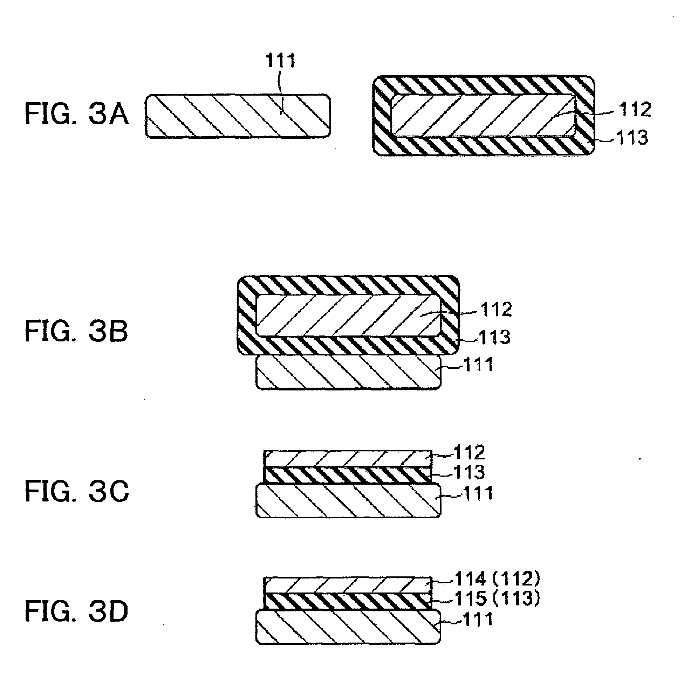

FIGS. 3A to 3D show a method of producing an SOI substrate by the bonding method. FIG. 3A shows a base substrate (base wafer) 111 and a bond substrate (bond wafer) 112. These both become the silicon substrates. The base substrate 111 is a silicon substrate for finally forming an SOI substrate and is common to the methods (2) and (3).

First, as shown in FIG. 3A, the bond substrate 112 is oxidized over its entire surface to form an oxide film 113. Next, as shown in FIG. 3B, the base substrate 111 and the bond substrate 112 are heat-bonded. Specifically, these substrates 111 and 112 are washed, then the substrates are brought into contact at room temperature and annealed at for example a temperature of 1100°C in oxygen gas for two hours to bond the substrates.

As shown in FIG. 3C, the bond substrate 112 is ground from the reverse side of the surface bonded with the base substrate 111. At this time, it is ground down to for example about 20 μm of the thickness of the silicon layer on the oxide film 113 bonded with the base substrate 111. As shown in FIG. 3D, the silicon layer of the bond substrate 112 is then polished to form an SOI layer 114. The oxide film 113 formed at the surface of the bond substrate 112 becomes the BOX layer 115.

With this method, it is difficult to make the SOI layer less than 1 μm in thickness. In the step of heat bonding, the two substrates and the oxide film between them expand under the heat. The oxide film becomes a viscous fluid in state, so the interface of the silicon layer and the oxide film becomes a stress-free state. As the temperature falls, both the silicon substrate and the oxide film shrink. However, the thermal expansion coefficient of silicon ($2.6 \times 10^{-6}$/K) is larger than the thermal expansion coefficient of silicon oxide ($0.5 \times 10^{-6}$/K). As a result, the oxide film is compressed by the substrate. This causes compressive stress of the BOX layer. This is described in for example T. Iida et al., *J. Appl. Phys. 87, 675* (2000).

(2) Hydrogen Ion Implantation and Peeling Method

This method is also based on a bonding step. For obtaining a thinner SOI layer, the bond substrate is implanted with hydrogen ions and peeled off at the interface formed thereby. This method applies to silicon the phenomenon that when a metal is impregnated with a large quantity of hydrogen atoms, it becomes brittle and fractures. By this method, an SOI layer having the thickness corresponding to the implantation depth of the hydrogen ions is formed and therefore an SOI layer having a thickness of less than 100 nm can be obtained.

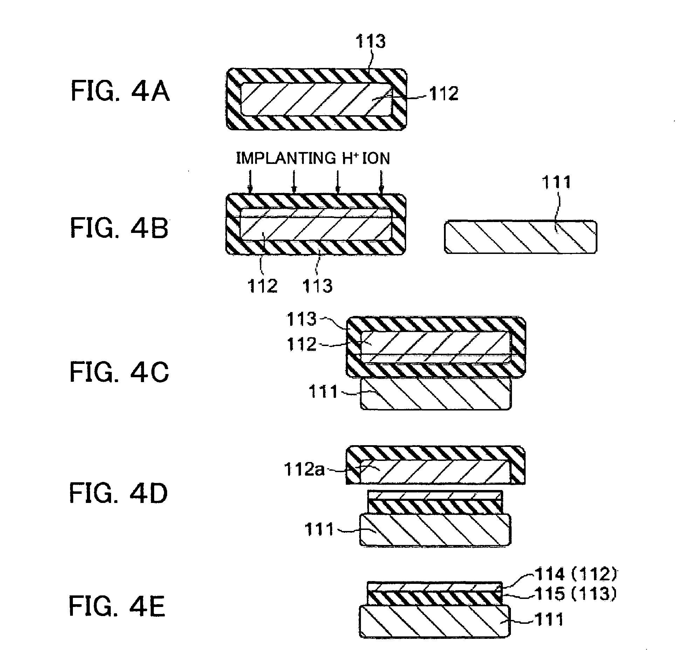

FIGS. 4A to 4E show a method of producing an SOI substrate by the hydrogen ion implantation and peeling method. As shown in FIG. 4A, a bond substrate 112 is oxidized to form an oxide film 113 at its surface. As shown in FIG. 4B, the bond substrate 112 is implanted with hydrogen ions up to a predetermined implantation depth. After washing the bond substrate 112 and a base substrate 111, as shown in FIG. 4C, they are bonded at room temperature.

As shown in FIG. 4D, heat is applied at a temperature of 400 to 600°C, whereby the bond substrate 112 fractures at the portions containing large amounts of hydrogen. The fractured bond substrate 112a, as shown in FIG 4B, can be used again as the base substrate 111. After fracturing the bond substrate 112, as shown in FIG. 4E, the reminder is annealing and touch-polished to form an SOI layer 114. The oxide film 113 formed at the surface of the bond substrate 112 becomes a BOX layer 115.

With this method, due to the same mechanism as the bonding method (1), compressive stress occurs at the BOX layer 115. This method was invented by Soitec of France and is named "Smart Cut" (registered trademark). In Japan, Shin-Etsu Handotai Co., Ltd., has concluded a long-term technical cooperation agreement with Soitec and is producing and selling the substrates as "UNIBOND" (registered trademark) wafers.

(3) Epitaxial Method

In this method, a bond substrate is successively formed with a porous silicon layer and an epitaxial silicon layer using single crystal silicon, oxidized at its surface, and bonded with a base substrate. The bond substrate is peeled off at the interface of the porous silicon layer having a weak bond strength by using a jet stream and treated on its surface to form a high quality SOI layer.

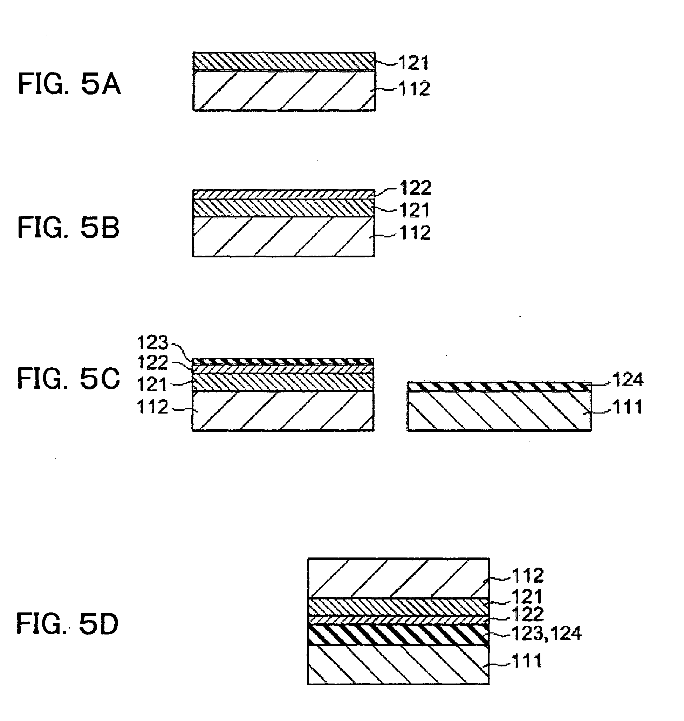

FIGS. 5A to 5F show a method of producing an SOI substrate by the epitaxial method. As shown in FIG. 5A, a p-type silicon substrate serving as the bond substrate 112 is anodized in a hydrofluoric acid-based solution to form a porous silicon layer 121 at its surface. The porous silicon layer 121 is a multiple layer of two porous silicon layers having different pore densities. As shown in FIG. 5B, the porous silicon layer 121 is formed with a single crystal silicon layer 122 by epitaxial growth.

As shown in FIG. 5C, the single crystal silicon layer 122 is oxidized at its surface to form an oxide film 123. The base substrate 111 is oxidized at its surface to form an oxide film 124. As shown in FIG. 5D, similar to the usual bonding method, these substrates 111 and 112 are washed and bonded by heat.

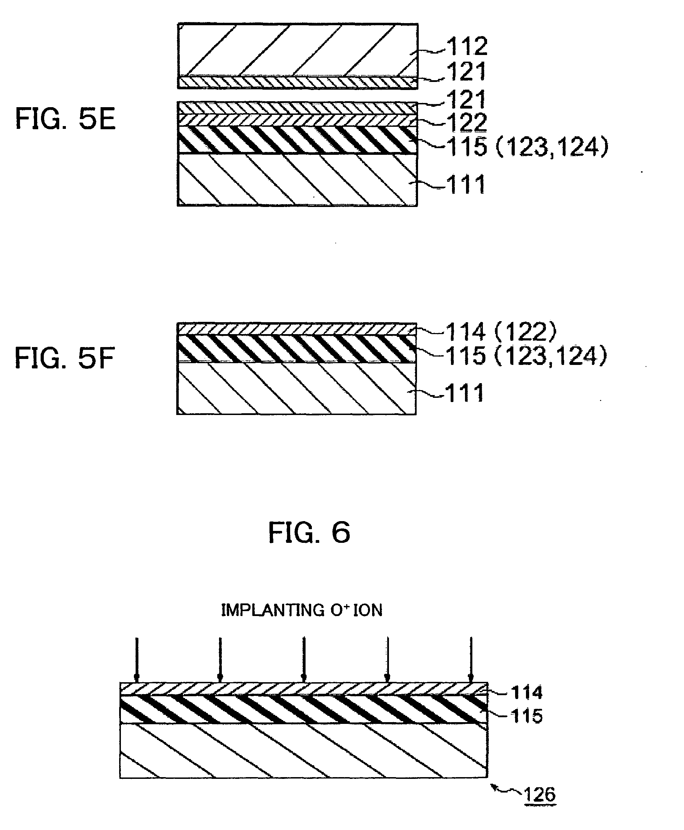

As shown in FIG. 5E, the end faces of the bonded substrates 111 and 112 are struck by a jet stream to separate the bond substrate 112 at the inside of the porous silicon layer 121. The separated bond substrate 112 can be used as a base substrate 111 again in the process shown in FIG. 5C.

As shown in FIG. 5F, the porous silicon layer 121 is removed by etching. Due to this, the single crystal silicon layer 122 becomes the SOI layer 114, the oxide film 123 and the oxide film 124 are formed with the BOX layer 115, and therefore an SOI substrate is obtained. Since the etching selectivity ratio of the porous silicon layer 121 is about 100,000 times the etching selectivity ratio of the SOI layer 114, the porous silicon layer 121 is selectively removed. In this method as well, compressive stress occurs at the BOX layer in the bonding step using heat. Canon developed this method and is producing and selling substrates by it as "ELTRAN" (registered trademark) wafers.

(4) Oxygen Ion Implantation Method

This method differs from the methods (1) to (3) and does not involve bonding. With this method, as shown in FIG. 6, a silicon substrate 126 is implanted with oxygen ions to form a layer of a high concentration of oxygen and then is heat treated to form an oxide layer serving as the BOX layer 115. The silicon portion on the BOX layer 115 becomes the SOI layer 114

With this method, while not involving bonding, in the steps of implanting ions, then heating to form an oxide and cooling after that, compressive stress again occurs at the BOX layer. However, it is believed that the warping of the substrate is smaller than with the other three methods. This type of SOI substrate is available as "Simox" wafers produced and sold by Sumitomo Mitsubishi Silicon Co.

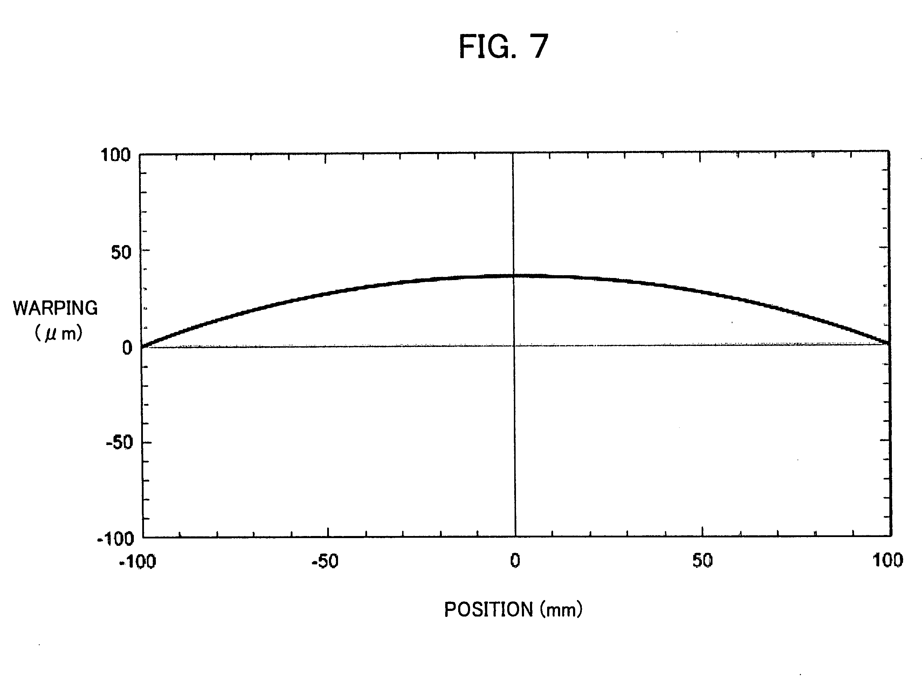

However, the BOX layer sometimes has a large compressive stress of no less than 300 MPa, so there is the problem that the SOI substrate ends up warping upward, that is, convexly at the thin film SOI layer side. FIG. 7 shows a shape of an 8-inch SOI substrate having a BOX layer with internal stress of 400 MPa and a thickness of 500 nm when placed on a flat surface. It will be understood that warping of about 40 μm occurs in the middle portion of the substrate.

The warping of the SOI substrate may decrease the positioning precision and dimensional precision of mask patterns transferred to the SOI substrate. When transferring mask patterns on the SOI substrate, the SOI substrate is fixed on a stage or a pallet of an electron beam (EB) lithography system and therefore has some flatness. Even if it is possible to transfer accurate mask patterns in this state, this would not necessarily mean that accurate mask patterns could be transferred to the wafer when forming a mask from the SOI substrate and exposing a wafer using the mask in an exposure system. That is, the method of holding the mask, that is, SOI substrate, at the exposure system differs from the method holding the SOI substrate at the EB lithography system, so the flatness of the SOI substrate will differ at the times of EB lithography and exposure.

Specifically, in the state where the mask is held at the EB lithography system, for example as shown in FIG. 7, the SOI substrate warps upward at the thin film SOI layer side. On the other hand, at the exposure system, the SOI substrate is used as a mask, so is arranged above the wafer. Due to this, the SOI substrate serving as a mask warps downward, that is, convexly at the wafer side, due to internal stress etc. The flatness of the SOI substrate is also affected by gravity, so the amount of warping when the SOI substrate warps upward convexly and the amount of warping when it warps downward convexly do not always match.

Therefore, the positions of mask patterns transferred to a wafer by an exposure system end up being displaced from the ideal positions. Further, since the mask patterns deform due to the warping of the mask formed by the SOI substrate, the dimensional precision of the transferred patterns deteriorates. Further, in the case of a method of exposure bringing the mask and substrate into proximity to about 50 μm such as LEEPL, the warping of the mask may cause contact accidents between the mask and the substrate.

The relationship of the internal stress of the BOX layer and the maximum warping $W_{max}$ of the substrate may be expressed by the following equation (1). Note that the influence of gravity is ignored for simplification.

$$w_{max} = \frac{3(1 - v)\sigma_0 ta^2}{Eh^2} \qquad (1)$$

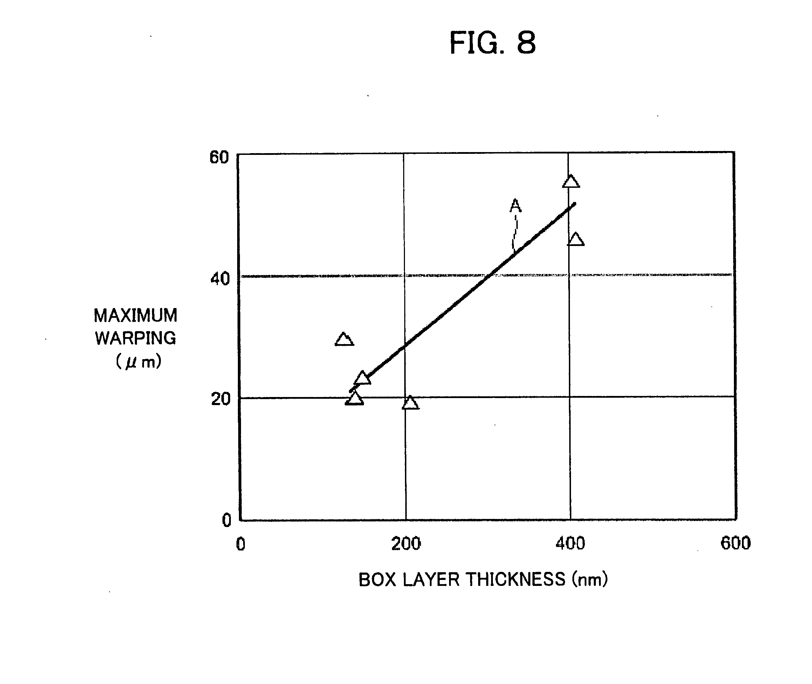

Here, "v" indicates the Poisson ratio of the substrate, "$\sigma_0$" indicates the internal stress of the BOX layer, "t" indicates the thickness of the BOX layer, "a" indicates the radius of the substrate, "E" indicates the Young's modulus of the substrate, and "h" indicates the thickness of the substrate. FIG. 8 is a graph showing the height of a substrate when changing the thickness of the BOX layer, measuring warping of the SOI substrate, and fitting the warp shape by a simple curved surface. "A" indicates a straight line for fitting, that is, y=0.110x+6.375 and $R^2$=0.797. By fitting the above equation (1) on this graph, the value of the internal stress of the BOX layer of $\sigma_0$=390 MPa is obtained. The maximum warping is proportional to the internal stress of the BOX layer. However, the internal stress of the BOX layer is a physical property determined in the process of producing the SOI substrate. Therefore, it is not easy to control this.

For solving the problem of occurrence of warping when producing a stencil mask using an SOI substrate, Japanese Unexamined Patent Publication (Kokai) No. 10-78650 discloses a mask (aperture) which has a symmetrical layer structure in the thickness direction. Specifically, both sides of the substrate are formed with a BOX layer and an SOI layer. However, the structure is obtained by etching a multilayer film in the step of etching the silicon substrate to form a support frame and struts of the membrane, so the process becomes complicated.

Further, the problem of the occurrence of warping of the SOI substrate is widely recognized in the production of devices as well. Methods for suppressing warping by using an SOI substrate for producing devices, not envisioning production of masks using SOI substrates, have been disclosed as follows.

Japanese Unexamined Patent Publication (Kokai) No. 9-45882 discloses to form oxide films having different thicknesses on a bond substrate and a base substrate and bond the bond substrate and base substrate via these oxide films. After that, the bond substrate is polished to form the SOI layer. According to this method, the oxide film of the bond substrate side and the oxide film of the base substrate side combine to form the BOX layer. The oxide film remaining at the surface of the base substrate on the opposite side to the bond substrate inevitably becomes thinner than the BOX layer. Therefore, it is difficult to optimize the process to balance the stress.

Japanese Unexamined Patent Publication (Kokai) No. 11-97320 discloses a method of production of an SOI substrate common with the above method in the point of forming an oxide film at the reverse surface of the SOI substrate, that is, the surface at the opposite side to the surface formed with the SOI layer, so as to balance the stress. However, the oxide film of the reverse surface is formed with a polycrystalline silicon layer as a protective film, so the surface oxide film formed at the SOI layer side is removed. Since the polycrystalline silicon layer also has a strong compressive stress, the stresses of the two surfaces do not become equal. Therefore, this method is not practical.

Japanese Unexamined Patent Publication (Kokai) No. 6-13593 discloses to form a silicon nitride film (SiN layer) having a tensile stress for offsetting a compressive stress of the BOX layer between the BOX layer and the silicon substrate so as to form a stack of an SOI layer, BOX layer, silicon nitride layer, and silicon substrate. However, in a step of etching the silicon substrate of a membrane region to form the substrate apertures when producing a mask using an SOI substrate, the etching processes of the silicon nitride film increases. Since the etching prevention layer used when etching the silicon substrate is changed from a BOX layer to a silicon nitride layer, it is necessary to optimize the process again.

Japanese Unexamined Patent Publication (Kokai) No. 7-74328 discloses a method for forming grooves at the BOX layer to decrease the warping of the SOI substrate. However, when producing a mask using an SOI substrate, since the silicon substrate is etched using the BOX layer as an etching prevention layer, when forming grooves at the BOX layer, the SOI layer serving as the membrane is etched at the portions of the grooves. Therefore, this method cannot be applied to an SOI substrate for producing a mask.

Japanese Unexamined Patent Publication (Kokai) No. 11-163309 discloses a method for suppressing warping when forming an integrated circuit on an SOI substrate. According to this method, to decrease the warping which occurs due to the stress of an insulation film of the integrated circuit, the silicon substrate is removed to expose the BOX layer and the BOX layer is made the reverse surface of the oxide film. This method cannot suppress warping due to compressive stress of the BOX layer and clearly cannot applied to a mask utilizing the silicon substrate as the support frame and the struts.

Japanese Unexamined Patent Publication (Kokai) No. 9-246556 discloses the method of using the BOX layer as an insulation film of the multilayer film and forming a layer having a tensile stress in the opposite direction to the compressive stress of the silicon oxide film on the silicon oxide film. According to this method, in the same way as the above method of forming a silicon nitride layer between the BOX layer and the silicon substrate, in the step of etching the silicon substrate to form a membrane, the etching processes of the BOX layer of the membrane region increase.

Japanese Unexamined Patent Publication (Kokai) No. 9-64318 discloses to form a silicon oxide film etc. at the reverse surface of an SOI substrate as a compensating layer for decreasing the warping of the substrate for a device formed by using an SOI substrate. However, this method is not directed to the production of a mask, so a process able to efficiently produce a mask is not shown.

Japanese Unexamined Patent Publication (Kokai) No. 5-275301 discloses a method for locally forming films having difference thermal expansion ratios corresponding to convex warping and the concave warping present in a substrate. However, this is not practical because of the complicated process.

As explained above, various methods have been proposed for decreasing warping in an SOI substrate for producing a device. These methods, however, cannot be applied to a method for producing a mask due to difference of the structures between devices and the mask.

SUMMARY OF THE INVENTION

A first object of the present invention is to provide a mask decreased in warping and having mask patterns with high positioning precision and a method of producing the same.

A second object of the present invention is to provide a mask blank able to produce a mask decreased in warping and a method of producing the same.

To achieve the first object, according to a first aspect of the invention, there is provided a mask having a silicon substrate; at least one substrate aperture formed at a portion of the silicon substrate; a first silicon oxide film formed at one surface of the silicon substrate; a single crystal silicon layer formed on the first silicon oxide film and on the substrate aperture; at least one aperture formed at a portion of the single crystal silicon layer on the substrate aperture and passing an exposure beam; and a stress controlling layer formed at another surface of the silicon substrate and having internal stress for flattening the warping of the silicon substrate due to at least a compressive stress of the first silicon oxide film, preferably due to the compressive stress and gravity.

Due to this, the warping of the mask due to at least the compressive stress of the first silicon oxide film can be decreased. Warping of the mask causes positional deviation of the mask patterns formed at the single crystal silicon layer. However, according to the mask of the present invention, the warping of the mask is prevented, so the positioning precision and the dimensional precision of the mask patterns are improved.

To achieve the first object, according to a second aspect of the invention, there is provided a method of producing a mask having the steps of forming a single crystal silicon layer at one surface of a silicon substrate via a first silicon oxide film; forming a stress controlling layer at another surface of the silicon substrate having internal stress for flattening the warping of the silicon substrate due to at least compressive stress of the first silicon oxide film; removing the stress controlling layer in any region for forming a substrate aperture; forming at least one substrate aperture at a portion of the silicon substrate with maintaining the stress controlling layer other than at any region for forming a substrate aperture; removing the first silicon oxide film on the substrate aperture; and forming at least one aperture at a portion of the single crystal silicon layer on the substrate aperture for passing an exposure beam.

Due to this, the warping of the silicon substrate due to at least the compressive stress of the first silicon oxide film is prevented, whereby a mask decreased in positioning deviation of the mask patterns due to warping can be produced.

To achieve the first object, according to a third aspect of the invention, there is provided a method of producing a mask having the steps of forming a single crystal silicon layer at one surface of a silicon substrate via a first silicon oxide film, oxidizing the entire exposed surface of the silicon substrate to form a second silicon oxide film as a stress controlling layer having internal stress for flattening warping of the silicon substrate due to at least compressive stress of the first silicon oxide film and form a third silicon oxide film on the surface of the single crystal silicon layer; removing the stress controlling layer in any region for forming a substrate aperture; forming at least one substrate aperture at a portion of the silicon substrate with maintaining the stress controlling layer other than at any region for forming the substrate aperture; removing the third silicon oxide film and the first silicon oxide substrate on the substrate aperture; and forming at least one aperture at a portion of the single crystal silicon layer on the substrate aperture for passing an exposure beam.

Due to this, warping of the silicon substrate due to at least the compressive stress of the first silicon oxide film is prevented, whereby a mask decreased in positioning deviation of the mask patterns due to warping can be produced. Further, according to the method of producing the mask of the present invention, the mask having the second silicon oxide film for preventing warping of the silicon substrate can be produced with fewer steps.

To achieve the second object, according to a fourth aspect of the present invention, there is provided a mask blank having a silicon substrate; a first silicon oxide film formed at one surface of the silicon substrate; a single crystal silicon layer formed on the first silicon oxide film; and a stress controlling layer formed at another surface of the silicon substrate and having internal stress for flattening warping of the silicon substrate due to at least compressive stress of the first silicon oxide film.

Further, to achieve the second object, according to a fifth aspect of the present invention, there is provided a method of producing a mask blank having the steps of oxidizing the entire surface of a silicon substrate to form a first silicon oxide film at one surface of the silicon substrate and to form a second silicon oxide film as a stress controlling layer at another surface of the silicon substrate and having internal stress for flattening warping of the silicon substrate due to compressive stress of the first silicon oxide film and having substantially the same thickness as the first silicon oxide film; forming a porous layer at one surface of another silicon substrate constituted by a bond substrate; forming a single crystal silicon layer on the porous layer having a thinner thickness than the silicon substrate; bonding the first silicon oxide film and the single crystal silicon layer formed on the bond substrate via the porous layer; dividing the porous layer into the silicon substrate side and the bond substrate side; and removing the porous layer of the silicon substrate side.

Further, to achieve the second object, according to a sixth aspect of the invention, there is provided a method of producing a mask blank having the steps of oxidizing the entire surface of a silicon substrate to form a first silicon oxide film at one surface of the silicon substrate and to form a second silicon oxide film as a stress controlling layer at another surface of the silicon substrate having internal stress for flattening warping of the silicon substrate due to compressive stress of the first silicon oxide film and having substantially the same thickness as the first silicon oxide film; implanting hydrogen ions in another silicon substrate constituted by a bond substrate down to a predetermined depth less than the thickness of the silicon substrate; bonding the bond substrate on the silicon substrate via the first silicon oxide film; and fracturing the bond substrate at a position of the highest concentration of hydrogen by heating to form a single crystal silicon layer formed by the bond substrate.

Further, to achieve the second object, according to a seventh aspect of the invention, there is provided a method of producing a mask blank having the steps of oxidizing the entire surface of a silicon substrate to form a first silicon oxide film at one surface of the silicon substrate and to form a second silicon oxide film as a stress controlling layer at another surface of the silicon substrate having internal stress for flattening warping of the silicon substrate due to compressive stress of the first silicon oxide film and having substantially the same thickness as the first silicon oxide film; bonding another silicon substrate constituted by a bond substrate on the silicon substrate via the first silicon oxide film; and reducing the thickness of the bond substrate from the silicon substrate to form a single crystal silicon layer formed by the bond substrate.

Further, to achieve the second object, according to an eighth aspect of the invention, there is provided a method of producing a mask blank having the steps of forming a stress controlling layer at one surface of a silicon substrate having internal stress for flattening warping of the silicon substrate due to at least compressive stress of the first silicon oxide film; implanting oxygen ions near another surface of the silicon substrate down to a predetermined depth; and forming the first silicon oxide film at a position of a highest concentration of oxygen of the silicon substrate by heating and forming a single crystal silicon layer at another surface of the silicon substrate.

Further, to achieve the second object, according to a ninth aspect of the invention, there is provided a method of producing a mask blank having the steps of forming a single crystal silicon layer at one surface of a silicon substrate via a first silicon oxide film and forming a stress controlling layer at another surface of the silicon substrate having internal stress for flattening warping of the silicon substrate due to at least compressive stress of the first silicon oxide film.

Due to this, warping of the silicon substrate due to at least compressive stress of the first silicon oxide film is decreased, whereby a mask having high positioning precision and high dimensional precision of the mask patterns can be produced. According to the mask blank and the method of producing the same of the present invention, it is possible to avoid an increase in the number of steps of producing the mask.

## BRIEF DESCRIPTION OF THE DRAWINGS

The above and other objects and features of the present invention will become clearer from the following description of the preferred embodiments given with reference to the attached drawings, wherein:

FIG. 1 is a plane view showing an example of a stencil mask;

FIG. 2 is a perspective view enlarging portion of FIG. 1;

FIGS. 3A to 3D are cross-sectional views of steps of producing a mask blank in the related art;

FIGS. 4A to 4E are cross-sectional views of steps of producing a mask blank in the related art;

FIGS. 5A to 5F are cross-sectional views of steps of producing a mask blank in the related art;

FIG. 6 is a cross-sectional view of a step of producing a mask blank in the related art;

FIG. 7 is a graph of the amount of warping of an SOI substrate in the related art;

FIG. 8 is a graph of a relation between the thickness of a BOX layer and the maximum warping of a substrate of an SOI substrate in the related art;

FIGS. 9A to 9F are cross-sectional views of steps of producing a mask blank according to a first embodiment of the present invention;

FIGS. 10A to 10H are cross-sectional views of steps of producing a mask according to the first embodiment of the present invention;

FIGS. 11A to 11D are cross-sectional views of steps of producing a mask blank according to a second embodiment of the present invention;

FIGS. 12A to 12D are cross-sectional views of steps of producing a mask blank according to a third embodiment of the present invention;

FIGS. 13A and 13B are cross-sectional views of steps of producing a mask blank according to a fourth embodiment of the present invention;

FIGS. 14A to 14C are cross-sectional views of steps of producing a mask blank according to a fifth embodiment of the present invention;

FIG. 15 is a cross-sectional view of a mask blank according to a sixth embodiment of the present invention;

FIGS. 16A to 16D are cross-sectional views of steps of producing a mask blank according to a seventh embodiment of the present invention; and

FIGS. 17A to 17G are cross-sectional views of steps of producing a mask according to the seventh embodiment of the present invention.

## DESCRIPTION OF THE PREFERRED EMBODIMENTS

Below, a mask, a mask blank, and methods of producing these of the present invention will be explained with reference to the accompanying drawings. The present invention proposes a method of producing a mask for suppressing warping of an SOI substrate due to compressive stress of a BOX layer and gravity and producing a mask having a high flatness.

According to the present invention, by forming at the reverse surface of an SOI substrate a thin film having stress for balancing internal stress of a BOX layer, that is, a stress controlling layer, it is possible to produce the SOI substrate having high flatness by using well established processes of production of the SOI substrate with almost no change. By using the SOI substrate, it is possible to obtain a stencil mask having a high positioning precision of patterns. Hereinafter, a high flatness SOI substrate obtained by the present invention will be referred to as a "super flat SOI substrate (SF-SOI substrate)".

The mask of the present invention is used for LEEPL and other lithography. In LEEPL, a low energy electron beam with an acceleration voltage of for example 2 kV is used as the exposure beam. In the mask of the present invention, however, the exposure beam is not limited to a low energy electron beam. The exposure beam may be a high energy electron beam with an acceleration voltage of several 10 to 100 kV or an ion beam, X-ray, or other electromagnetic wave.

In the following first embodiment to fourth embodiment, methods of producing mask blanks constituting the methods of production of SOI substrates of the related art improved for producing masks and methods of producing masks including them will be explained. In the fifth embodiment to seventh embodiment, methods of producing mask blanks by later treating existing SOI substrates to flatten the substrates and methods of producing masks including them will be explained.

First Embodiment

According to the first embodiment to the third embodiment, in the methods involving bonding of substrates among the methods of producing SOI substrates of the related art explained above, that is, the (1) bonding method, (2) hydrogen ion implantation and peeling method, and (3) epitaxial method, the base substrate is oxidized over its entire surface instead of oxidizing the entire surface of the bond substrate. The base substrate is a silicon substrate forming the finally obtained SF-SOI substrate.

In the first embodiment, the explanation will be given of a method of improving the method particularly favorable for enhancing the evenness of the thickness and quality of the SOI layer even when making the SOI layer thin among the methods (1) to (3), that is, the (3) epitaxial. FIGS. 9A to 9F show a method of producing the SF-SOI substrate of the present invention.

First, as shown in FIG. 9A, a bond substrate (bond wafer) 2 constituted by a p-type silicon substrate is anodized in a hydrofluoric acid-based solution to form a porous silicon layer 11 on its surface. In the anodizing process, the bond substrate 2 is used as a cathode and current is passed in a solution containing hydrofluoric acid and ethanol to form fine pores of several nm at the surface of the bond substrate 2. The structure of the pores is controlled by the concentration of the solution, the current density, and the resistively of silicon. The thickness of the porous silicon layer 11 is determined by the time of passing the current. The porous silicon layer 11 is formed by a stack of two porous silicon layers having different pore densities.

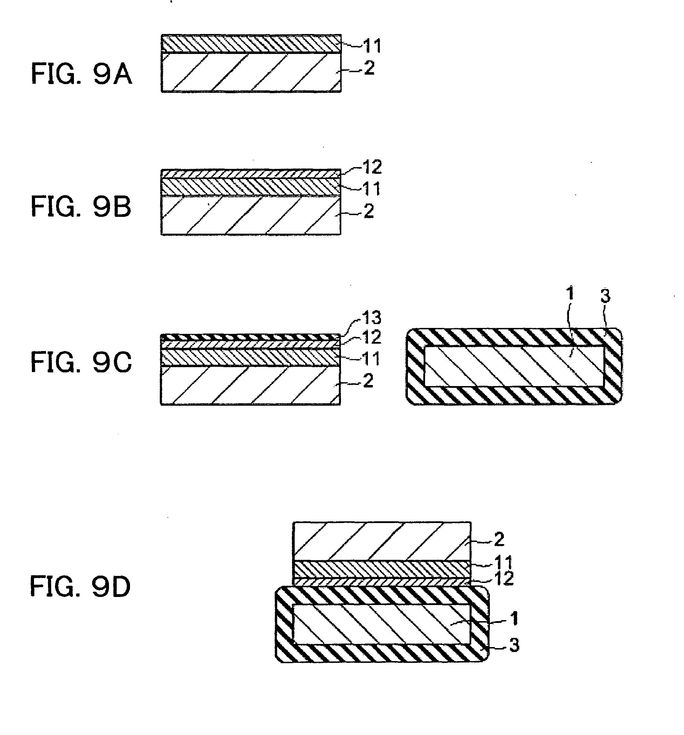

As shown in FIG. 9B, the porous silicon layer 11 is formed with a single crystal silicon layer 12 by epitaxial growth. As shown in FIG. 9C, the single crystal silicon layer 12 is then oxidized to form an oxide film 13. Note that the bond substrate 2 and base substrate (base wafer) 1 can be bonded without forming the oxide film 13, so the oxide film 13 does not always have to be formed.

On the other hand, the base substrate 1 is oxidized over its entire surface in a usual thermal oxidation furnace to form an oxide film 3. The oxide film 3 formed at the surface of the base substrate 1 for bonding with the bond substrate 2 is made the first silicon oxide film. Further, the oxide film 3 formed at another surface of the base substrate 1, that is, the reverse surface of the SF-SOI substrate, becomes the second silicon oxide film serving as a stress controlling layer.

As shown in FIG. 9D, in the same way as the usual bonding method, the base substrate 1 and the bond substrate 2 are washed and heat-bonded. Specifically, the substrates 1 and 2 are washed, then brought into contact at room temperature and annealed at a temperature of 1100°C in oxygen gas for two hours to bond the two substrates.

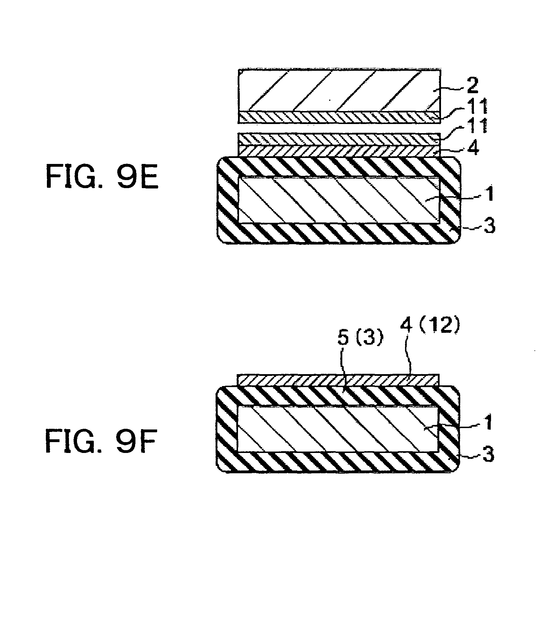

As shown in FIG. 9E, the end faces of the bonded substrates 1 and 2 are struck with a jet stream to separate the bond substrate 2 at the inside of the porous silicon layer 11. The divided bond substrate 2 can be used as the base substrate 1 again as shown in FIG. 9C.

As shown in FIG. 9F, the porous silicon layer 11 on the oxide film 3 is removed by etching. Due to this, the single crystal silicon layer 12 becomes the SOI layer 4, the oxide film 3 adjoining the SOI layer 4 becomes the BOX layer 5, and thereby an SOI substrate can be obtained. Since the etching selectivity ratio of the porous silicon layer 11 is about 100,000 times the etching selectivity ratio of the SOI layer 4, the porous silicon layer 11 is selectively removed.

Further, if not reusing the bond substrate 2 separated after bonding, instead of emitting the jet stream to separate the bond substrate 2 from the base substrate 1, the bond substrate 2 may be removed by grinding. In this case, the porous silicon layer 11 remaining on the single crystal silicon layer 12, that is, the SOI layer 4, after the grinding is removed by etching.

In the step of heat bonding, the interface between the silicon layer and oxide film becomes stress-free in state. Along with the drop in the temperature, the silicon substrate and oxide film shrink. The thermal expansion coefficient of silicon ($2.6 \times 10^{-6}$/K) is larger than the thermal expansion coefficient of silicon oxide ($0.5 \times 10^{-6}$/K), so the oxide film is compressed by the substrate in this step.

However, the SF-SOI substrate formed by the present embodiment is left with the oxide film 3, that is, the second silicon oxide film, of the same thickness as the BOX layer 5, that is, the first silicon oxide film, at the reverse surface of the base substrate 1, that is, the reverse surface of the bond surface 2. Due to this, the two surfaces of the base substrate are balanced in the compressive internal stress of the oxide films and an extremely flat substrate can be obtained.

The method of producing a mask blank of the present embodiment is similar to the epitaxial method of the related art except for forming the oxide film 3 for forming the BOX layer at the base substrate side instead of the bond substrate side and there has the advantage of not requiring major changes in the process.

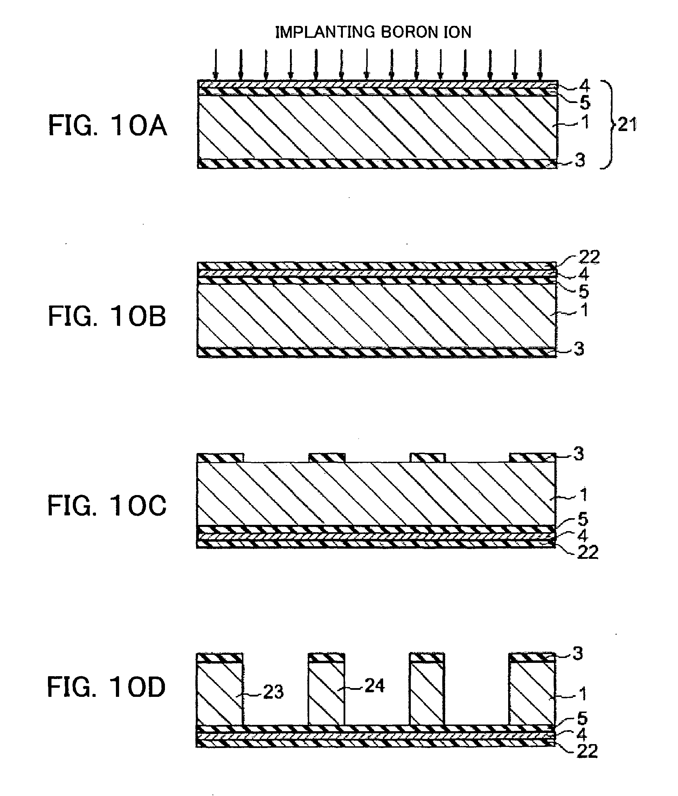

Next, a method of producing a stencil mask using an SF-SOI substrate formed by above steps as a mask blank will be explained. There are various methods of producing a stencil mask. One example is shown in FIGS. 10A to 10H, but the invention is not limited to this example.

First, as shown in FIG. 10A, an SF-SOI substrate 21 is doped with boron by ion implantation at its front surface side, that is, the SOI layer 4 side, to adjust the internal stress of the SOI layer 4. The SF-SOI substrate 21 has the SOI layer 4 on a silicon substrate 1 via a BOX layer 5 and has an oxide film 3 at the reverse surface. The SF-SOI substrate 21 is a high flatness substrate balanced in the internal stresses of the BOX layer 5 and the oxide film 3 formed at the reverse surface.

As shown in FIG. 10B, the SOI layer 4 is formed with a protective film 22. The protective film 22 may be made from a resist, resin film, polycrystalline silicon film, etc. The material is not particularly limited so long as it is not etched in the step of etching the oxide film 3.

As shown in FIG. 10C, the oxide film 3 is removed in regions for forming the membrane. The etching of the oxide film 3 is performed using a resist (not shown) as a mask. Next, as shown in FIG. 10D, the oxide film 33 is used as a mask to deeply etch the silicon substrate 1 from the reverse surface. The etching is performed until reaching the BOX layer 5.

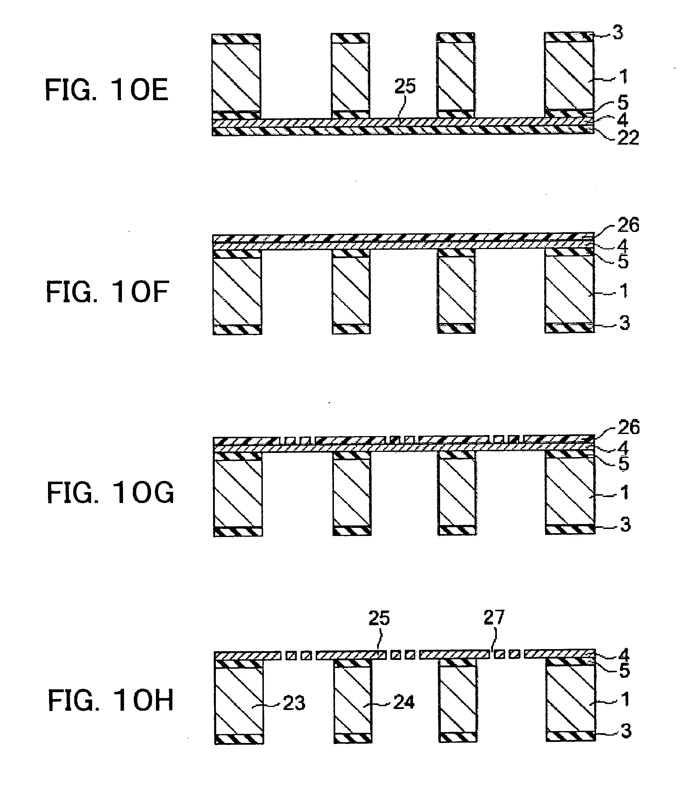

Since the etching rates of silicon and silicon oxide differ by several orders of magnitude, it is easy to stop etching at the BOX layer 5. Among the non-etched portions of the silicon substrate 1, the portion near the edge of the silicon substrate 1, that is, the circumference of the substantially disk shaped silicon substrate 1, becomes a support frame 23 and the portions separating the membrane regions become struts 24. After this, as shown in FIG. 10E, the exposed BOX layer 5 is removed by a hydrofluoric acid-based solution. Due to this, a membrane 25 comprised of silicon is formed.

As shown in FIG. 10F, the protective film 22 is removed, then the SOI layer 4 is coated with a resist 26. The substrate coated with the resist 26 is fixed at an EB lithography system, where the mask patterns are transferred and the resist 26 developed to pattern the resist 26 as shown in FIG. 10G.

As shown in FIG. 10H, the membrane 25 is etched using the resist 26 as a mask to form apertures 27 for passing the exposure beam, for example, an electron beam in the case of LEEPL, then the resist 26 is removed. Due to this, a stencil mask is completed. According to the method of producing the mask of the above present embodiment, the oxide film 3 at the reverse surface of the SOI substrate is not removed, but left, so the internal stresses of the oxide film 3 and the BOX layer 5 become equal and warping of the mask is prevented.

Therefore, in the step of transferring the mask patterns, referred to FIG. 10G, the membrane 25 becomes flat and a drop in the pattern positioning precision due to warping of the mask is prevented. When using the stencil mask for exposure, the mask is fixed at the exposure system with the struts 24 at the top and the membrane 25 at the bottom. In this case as well, similar to when transferring the mask patterns, the membrane 25 becomes flat, so a drop in the pattern positioning precision exposed is prevented.

Second Embodiment

FIGS. 11A to 11D show a method of producing an SF-SOI substrate of a second embodiment. This method of producing an SF-SOI substrate constitutes the hydrogen ion implantation and peeling method of the related art improved for the producing a mask. First, as shown in FIG. 11A, the bond substrate 2 is implanted with hydrogen ions down to a predetermined implantation depth.

For preventing damage to the substrate due to ion implantation, the bond substrate 2 may be formed with a buffer use oxide film 6 on its surface before implanting the ions. The oxide film 6 is clearly thinner than an oxide film formed on the surface of the bond substrate 2 in the hydrogen ion implantation and peeling method of the related art. Specifically, the thickness of the oxide film 6 is no more than several % of the BOX layer 5 and the oxide film 3 forming the stress controlling layer. On the other hand, the base substrate 1 is oxidized over its entire surface by the usual thermal oxidation furnace to form an oxide film 3.

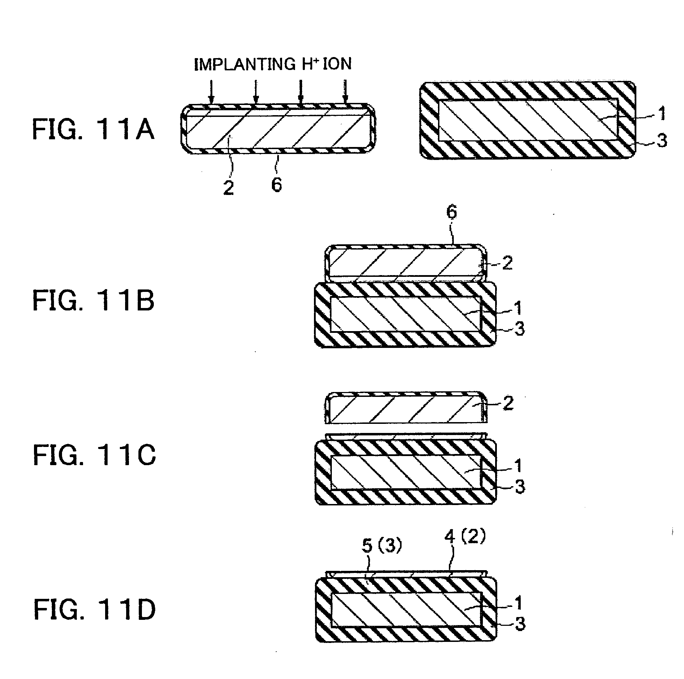

Next, as shown in FIG. 11B, the bond substrate 2 and the base substrate 1 are washed and bonded at room temperature. Next, as shown in FIG. 11C, they are heated to a temperature of 400 to 600°C to fracture the bond substrate 2 at the portion in the highest hydrogen content. The fractured bond substrate 2 can be reused as the base substrate 1 as shown in FIG. 11A. After fracturing the bond substrate 2, as shown in FIG. 11D, the remaining substrate is annealed and touch-polished to form the SOI layer 4. In the oxide film 3 formed on the surface of the base substrate 1, the portion adjoining to the SOI layer 4 becomes the BOX layer 5.

In the SF-SOI substrate formed by the present embodiment as well, the reverse surface of the base substrate 1, that is, the surface opposite to the bond substrate 2, is left with an oxide film 3, that is, the second silicon oxide film, as the stress controlling layer with the same thickness as the BOX layer 5, that is, the first silicon oxide film. Due to this, the two surfaces of the base substrate become balanced in compressive internal stresses of the oxide films, so an extremely flat substrate can be obtained.

The method of the present embodiment is similar to the hydrogen ion implantation and peeling method of the related art except for forming the oxide film 3 for forming the BOX layer at the base substrate side instead of the bond substrate side and there has the advantage that no major changes in the process are required. Even when using an SF-SOI substrate produced by the present embodiment as a mask blank, a mask can be produced in the same way as the method of producing a mask of the first embodiment.

Third Embodiment

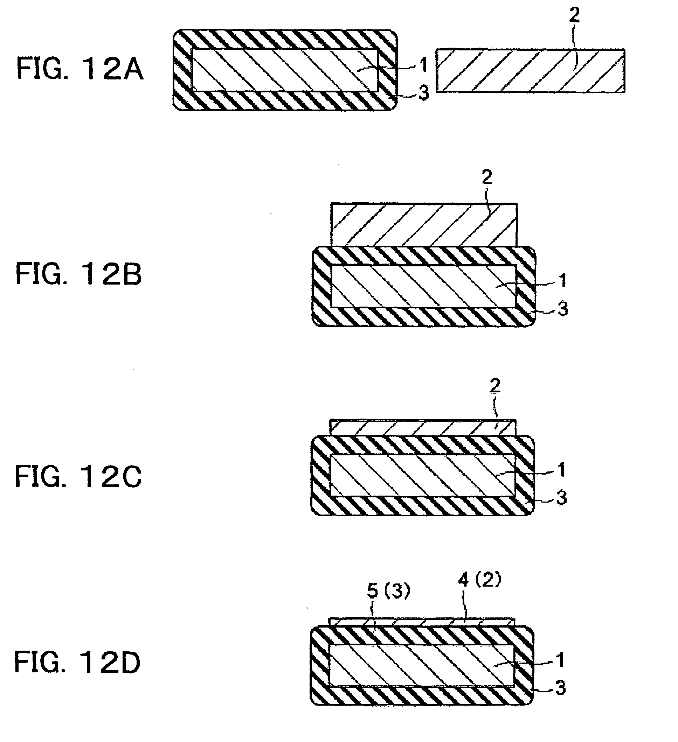

FIGS. 12A to 12D show a method of producing an SF-SOI substrate of a third embodiment. This method of producing an SF-SOI substrate constitutes the bonding method of the related art improved for producing a mask. First, as shown in FIG. 12A, a base substrate 1 is oxidized over its entire surface to form an oxide film 3. When using a usual thermal oxidation furnace, the two surfaces of the substrate are oxidized uniformly. The base substrate 1 and a bond substrate 2 are silicon substrates.

As shown in FIG. 12B, in the same way as the usual bonding method, the base substrate 1 and the bond substrate 2 are heat-bonded. As shown in FIG. 12C, the bond substrate 2 is ground from its top side, that is, the opposite side to the base substrate 1. Here, the bond substrate 2 is ground down to for example about 20 μm of the thickness of the silicon on the oxide film 3. As shown in FIG. 12D, the silicon of the bond substrate 2 is polished to form an SOI layer 4. In the oxide film 3 formed at the surface of the base substrate 1, the portion contacting the SOI layer 4 becomes the BOX layer 5.

In the SF-SOI substrate formed by the present embodiment as well, the reverse surface of the base substrate 1, that is, the surface at the opposite side to the bond substrate 2, is left with the oxide film 3, that is, a second silicon oxide film, as the stress controlling layer with the same thickness as the BOX layer 5, that is, the first silicon oxide film. Due to this, the two surfaces of the base substrate 1 are balanced in compressive internal stresses of the oxide films, so an extremely flat substrate can be obtained.

The method of the present embodiment is similar to the bonding method of the related art except for forming the oxide film 3 for forming the BOX layer 5 at the base substrate side instead of the bond substrate side and therefore has the advantage that no major changes in the process are required. When using an SF-SOI substrate produced by using the method of the present embodiment as a mask blank, a mask can be produced in the same way as the method of producing a mask of the first embodiment.

Fourth Embodiment

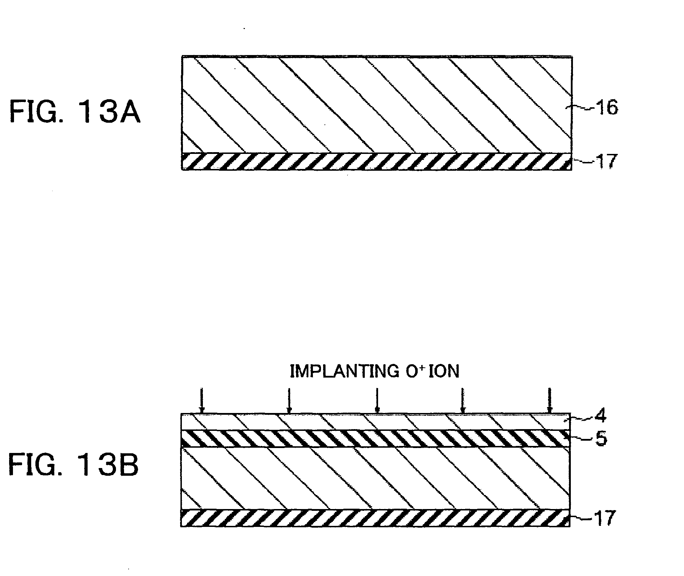

FIGS. 13A to 13B show a method of producing an SF-SOI substrate of a fourth embodiment. This method of producing the SF-SOI substrate constitutes the oxygen ion implantation method of the related art improved for producing a mask. The present embodiment differs from the first to the third embodiments in that it does not involve bonding the substrates, therefore cannot use the method of oxidizing the entire surface of the base substrate to form oxide films at the two surfaces having the same thickness.

As shown in FIG. 13A, a silicon substrate 16 is formed at its reverse surface with an oxide film 17 as a stress controlling layer. Due to this, convex warping is caused at the reverse surface of the silicon substrate 16. To form the oxide film 17 only at the reverse surface of the silicon substrate 16, for example, an easily removable polycrystalline silicon layer is formed as a protective film at its surface and heated by a thermal oxidation furnace.

After forming the oxide film 17 by heating, the protective film formed at its surface is removed. Any layer able to be removed by dry etching and wet etching under conditions where the oxide film 17 will not be etched can be used as the protective film for protecting the surface of the silicon substrate 16.

As shown in FIG. 13B, the silicon substrate 16 is implanted with oxygen ions to form a layer of a high concentration of oxygen and then is heat treated to form an oxide layer for forming the BOX layer 5. The silicon portion on the BOX layer 5 becomes the SOI layer 4. According to the SF-SOI substrate formed by the present embodiment, the BOX layer 5, that is, the first silicon oxide film, and the oxide film 17 at the reverse surface, that is, the stress controlling layer, can be balanced in compressive internal stress. Therefore, an extremely flat substrate can be obtained.

In the first to the third embodiments, the oxide films at the two surfaces of the base substrate were formed by the same steps. In the present embodiment, the BOX layer 5 and the reverse surface oxide film 17 are formed by different steps. Therefore, in general, the internal stresses will differ. Even if forming both layers with the same thicknesses, the stresses will not necessarily be balanced. Therefore, the conditions for forming the BOX layer 5 and the oxide film 17 are optimized by simulation or experiments. At that time, it is desirable to consider warping of the substrate due to gravity and control the thicknesses and the internal stresses of the BOX layer 5 and the oxide film 17 for flattening the substrate.

The method of the present embodiment is similar to the oxygen ion implantation method of the related art except for forming the oxide film 17 at the reverse surface of the silicon substrate 16 beforehand and therefore has the advantage that no major changes of the process are required. When using an SF-SOI substrate produced by the method of the present embodiment as a mask blank, a mask can be produced in the same way as the method of producing a mask of the first embodiment.

Fifth Embodiment

In the fifth embodiment, the reverse surface of an SOI substrate produced by a method of the related art is formed with a thin film having compressive stress as a stress controlling layer so as to balance with the stress of the BOX layer. In general, in thermal oxidation of a silicon substrate, both surfaces are oxidized by exactly the same amounts. Therefore, the surfaces of the SOI substrate are protected by polycrystalline silicon layers or other easily removable protective films and then oxidized in a thermal oxide furnace.

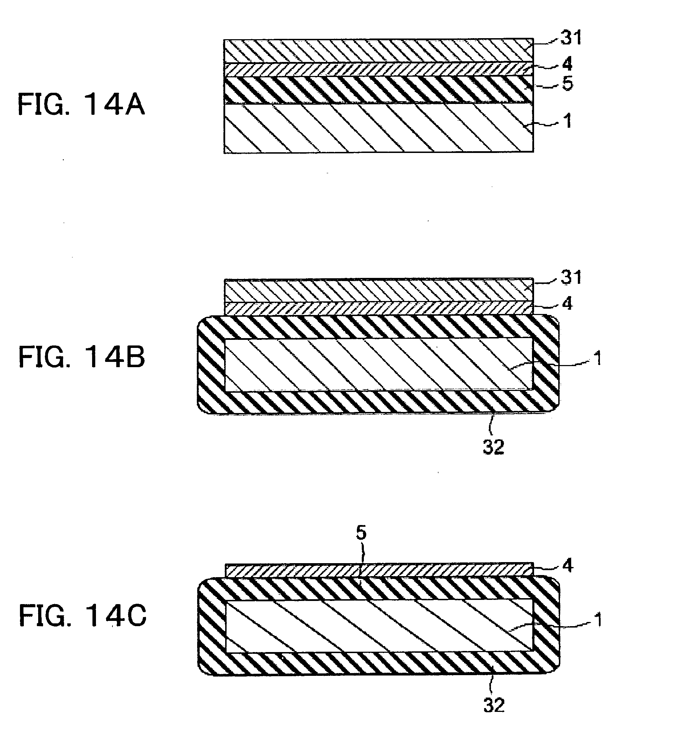

FIGS. 14A to 14 C show a method of producing a SF-SOI substrate of the fifth embodiment. First, as shown in FIG. 14A, an SOI substrate is formed at its front surface, that is, the SOI layer 4 side, with a polycrystalline silicon layer or other protective film 31. The SOI substrate may be produced by any of the bonding method, hydrogen ion implantation and peeling method, epitaxial method, and oxygen ion implantation method.

As shown in FIG. 14B, the SOI substrate is formed at its reverse surface with an oxide film 32 by thermal oxidation. After that, as shown in FIG. 14C, the protective film 31 is removed. Due to this, an SF-SOI substrate is formed. When using an SF-SOI substrate produced by the present embodiment as a mask blank, a mask can be produced in the same way as the method of producing a mask of the first embodiment.

For the amount of oxidation of the reverse surface of the SOI substrate, it is possible to use the thickness of the BOX layer as a yardstick. The process has to be optimized for forming a high flatness substrate. At this time, the amount of the oxidation of the reverse surface is controlled also considering warping of the SOI substrate due to gravity. For example, in the same way as when holding a mask in an LEEPL or other exposure system, it is possible to measure warping of the substrate using a laser measurement system etc. in the state with the BOX layer and the SOI layer below the silicon substrate and optimize the process for oxidizing the reverse surface so that the flatness becomes the highest.

As a laser measurement system, for example, a noncontact shape measuring system using a laser autofocus function, for example, Model YP20/21 made by Sony Precision Technology Inc., may be mentioned. If warping of the substrate can be measured in the oxidation furnace or can be measured from the outside through a glass window etc., more sophisticated process control using in-situ measurement of warping would be possible.

Sixth Embodiment

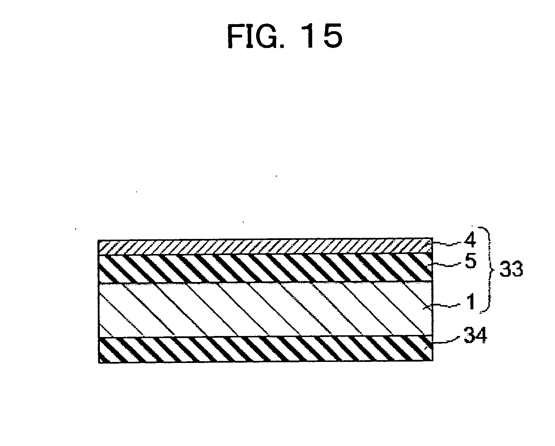

In the sixth embodiment, as shown in FIG. 15, an SOI substrate 33 produced by a method of the related art is formed at only its reverse surface with a thin film having compressive stress as a stress controlling layer 34. Since using the method of forming the thin film only at the reverse surface of the substrate, the SOI substrate 33 does not have to be protected at its front surface by a resist etc. For example, a polycrystalline silicon layer formed by low-pressure chemical vapor deposition (LPCVD), a silicon oxide film formed by plasma enhanced CVD (PECVD), or a gold or other metal layer formed by sputtering have compressive stress.

These thin films are deposited so as to satisfy the condition of equation (2).

$$\sigma_0 t = \sigma_c t_c \tag{2}$$

Here, "$\sigma_0$" indicates the internal stress of the BOX layer, "t" indicates the thickness of the BOX layer, "$\sigma_c$" indicates the internal stress of the stress controlling layer, and "$t_c$" indicates the thickness of the stress controlling layer.

Alternatively, considering warping of the substrate due to gravity, the stress controlling layer is deposited so as to satisfy the condition of equation (3).

$$\frac{3(1-v)\sigma_0 t a^2}{E h^2} + w_g = \frac{3(1-v)\sigma_c t_c a^2}{E h^2} \tag{3}$$

Here, the first term on the left side is the "$w_{max}$" shown in equation (1), "v" indicates the Poisson ratio of the substrate, "$\sigma_0$" indicates the internal stress of the BOX layer, "t" indicates the thickness of the BOX layer, "a" indicates a radius of the substrate, "E" indicates the Young's modulus of the substrate, and "h" indicates the thickness of the substrate. Further, "$W_g$" indicates the amount of warping of the substrate due to gravity, "$\sigma_c$" indicates the internal stress of the stress controlling layer, and "$t_c$" indicates the thickness of the stress controlling layer. The amount of the warping of the substrate is measured by using a laser measuring apparatus similar to the fifth embodiment.

According to the present embodiment as well, the stresses of the BOX layer 5 and the reverse surface stress controlling layer 34 can be balanced. When using an SF-SOI substrate produced by the method of the present embodiment as a mask blank, a mask can be produced in the same way as the method of producing a mask of the first embodiment.

Seventh Embodiment

In the seventh embodiment, an SOI substrate produced by a method of the related art is oxidized over its entire surface, then left with the oxide film at its reverse surface by removing an oxide film at its front surface, whereby an oxide film serving as a stress controlling layer is formed only at the reverse surface.

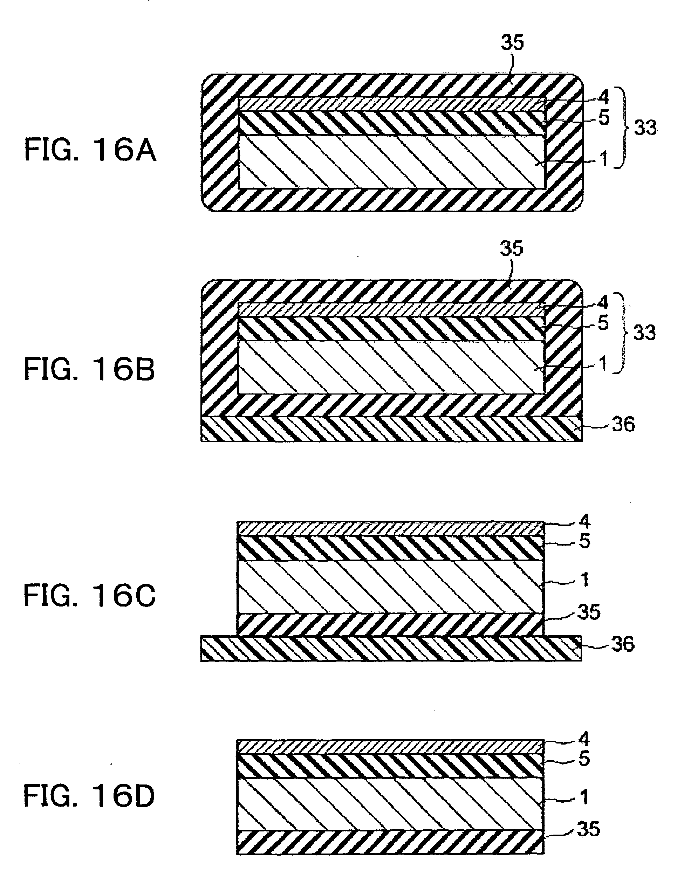

FIGS. 16A to 16D show a method of producing an SF-SOI substrate of the seventh embodiment. First, as shown in FIG. 16A, an SOI substrate 33 is oxidized over its entire surface to form an oxide film 35 at its two surfaces. At that time, the compressive stress of its front surface is strong due to the presence of the BOX layer, so the substrate warps upward convexly.

As shown in FIG. 16B, the oxide film 35 of the reverse surface of the SOI substrate is protected by a resist 36. Instead of the resist 36, a resin film or other layer enable to be easily removed by a removing solution or ashing may be formed. After this, as shown in FIG. 16C, the SOI substrate is dipped in a hydrofluoric acid-based solution to remove the oxide film 35 formed on its front surface. As shown in FIG. 16D, the resist 36 is removed.

Due to this, the oxide film 35 is left only at the reverse surface of the SOI substrate. Instead of dipping in a hydrofluoric acid-based solution, the oxide film 35 of the front surface can also be removed by dry etching. According to the present embodiment as well, since the stresses of the BOX layer 5 and gravity and the reverse surface oxide film are balanced, the mask is made flat.

When using an SF-SOI substrate produced by the method of the present embodiment as a mask blank, a mask can be produced in the same way as the method of producing a mask of the first embodiment. Alternatively, the method of producing an SF-SOI substrate of the present embodiment can be performed as portion of the process of producing a stencil mask shown hereinafter. In this case, a mask having a stress controlling layer can be produced without increasing the steps of producing a mask of the related art.

Below, a method of producing a mask of the present embodiment will be explained. In the method of producing the mask of the first embodiment, an SF-SOI substrate having a high flatness was formed, then the mask was produced by the steps shown in FIG. 10A to 10H. In the present embodiment, a usual SOI substrate having a low flatness and warped upward convexly is started from and formed with a stress controlling layer for offsetting the compressive stress of the BOX layer and the influence of gravity in the middle of the process so as to finally obtain a mask having a high flatness.

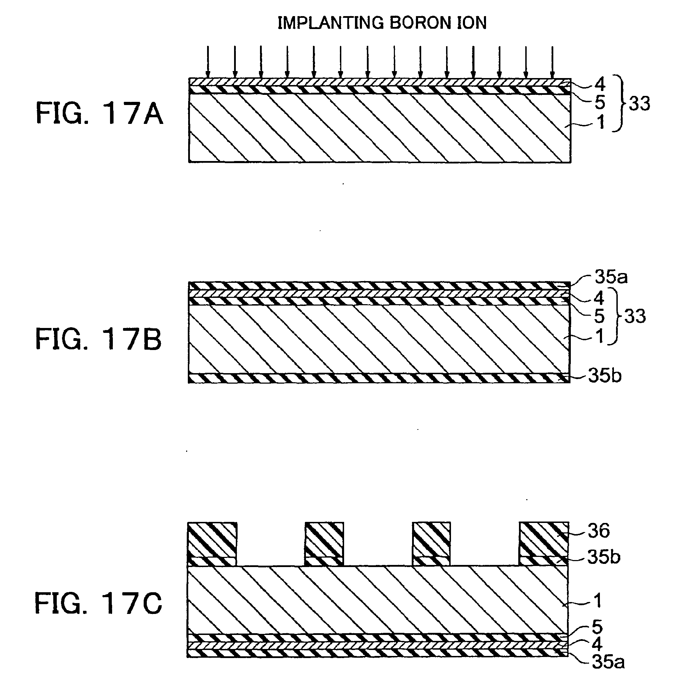

According to the method of producing a mask of the present embodiment, as shown in FIG. 17A, a usual SOI substrate 33 is doped with boron by ion implantation at its front surface, that is, the SOI layer 4 side, to adjust the internal stress of the SOI layer 4. The SOI substrate 33 has the SOI layer 4 on the silicon substrate 1 via the BOX layer 5.

Next, as shown in FIG 17B, the SOI substrate 33 is oxidized over its entire surface to form oxide films 35a and 35b at the two sides having the same thickness. Here, the oxide film 35a formed at the front surface of the SOI substrate 33 functions as the protective film of the SOI layer 4 in the step of etching the silicon substrate 1 from the reverse surface to form a support frame and struts. On the other hand, the oxide film 35b formed at the reverse surface of the SOI substrate 33 functions as an etching mask in the step of etching the silicon substrate 1. Therefore, according to the present embodiment, the protective film of the surface and the etching mask of the reverse surface can be formed in the same step.

As shown in FIG. 17C, the oxide film 35b is coated with a resist 36 on its reverse surface and then the resist 36 is removed from regions forming the membrane. The oxide film 35b is etched using the resist 36 as a mask to expose the silicon substrate 1.

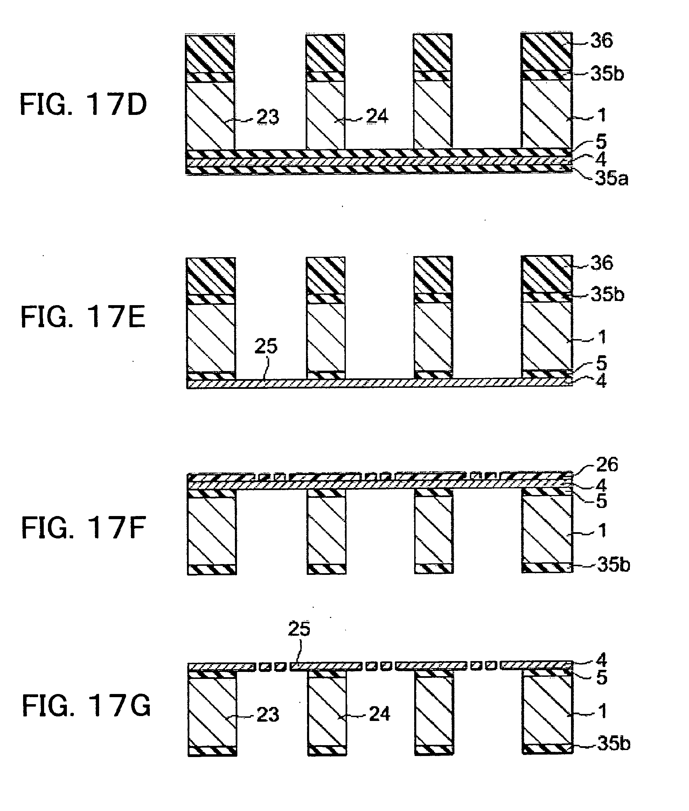

As shown in FIG. 17D, leaving the resist 36 as it is, the silicon substrate 1 is deeply etched from its reverse surface using the resist 36 as a mask. The etching is performed until reaching the BOX layer 5. Among the non-etched portions of silicon substrate 1, the portion near the edge of the silicon substrate 1 becomes the support frame 23 and the portions separating the membrane regions become the struts 24.

In the present embodiment, the oxide film 35b is protected by the resist 36 from etching in the following step of removing the oxide film 35a of the front surface of the SOI substrate. Therefore, the resist 36 is formed to a thickness enough that it will not be removed in the step of etching the silicon substrate 1 deeply.

After etching silicon substrate 1, as shown in FIG. 17E, the substrate is dipped in a hydrofluoric acid-based solution to remove the BOX layer 5 of the membrane portions and the oxide film 35a of the front surface side. Due to this, the membrane 25 is formed. At that time, if the oxide film 35b was also removed, convex warping would occur at the SOI layer 4 side of the substrate due to the compressive stress of the BOX layer 5. Since the resist 36 is kept, however, the oxide film 35b is protected. Therefore, the balance of the stresses is maintained and warping of the substrate does not occur. Further, since the thickness of the oxide film 35b is suitably controlled, the warping of the substrate due to gravity is cancelled. After removing the BOX layer 5 of the membrane portions and the oxide film 35a, the resist 36 is removed.

In the following steps, in the same way as the first embodiment, as shown in FIG. 17F, the SOI layer 4 is formed with a resist 26 in the mask patterns. The membrane 25 is etched using the resist 26 as a mask and then the resist 26 is removed, whereby a stencil mask is formed as shown in FIG. 17G.

According to the method of producing a mask of the present embodiment, since the oxide film 35b of the SOI substrate is left without being removed, the internal stresses of the BOX layer 5 and gravity and the oxide film 35b are balanced and warping of the mask is prevented.

The mask, mask blank, and methods of producing these of the present invention are not limited to the above explanations. For example, the methods of producing the SF-SOI substrate shown in the above embodiments of the present invention can be combined with methods of producing a mask other than those shown in the first to the seventh embodiments so as to produce a mask.

For example, the mask patterns can be transferred or the membrane etched before etching the silicon substrate to form the struts. Further, the SF-SOI substrate produced by the method of producing the mask blank of the present embodiments can be used for purposes other than producing the mask such as producing a device.

Summarizing the effects of the invention, according to the masks of the present invention, warping of a mask is decreased and the positioning precision and the dimensional precision of the mask patterns are improved. According to the methods of producing a mask of the present invention, a mask decreased in warping can be produced.

According to the mask blanks of the present invention, a mask decreased in warping of the substrate when transferring mask patterns and having high positioning precision of the mask patterns can be produced. According to the methods of producing a mask blank of the present invention, a mask blank suppressed in warping can be produced.

While the invention has been described with reference to specific embodiments chosen for purpose of illustration, it should be apparent that numerous modifications could be made thereto by those skilled in the art without departing from the basic concept and scope of the invention.

## Claims

1. A mask comprising:

   a silicon substrate;
   at least one substrate aperture formed at a portion of said silicon substrate;
   a first silicon oxide film formed at one surface of said silicon substrate;
   a single crystal silicon layer formed on said first silicon oxide film and on said substrate aperture;
   at least one aperture formed at a portion of said single crystal silicon layer on said substrate aperture and passing an exposure beam; and
   a stress controlling layer formed at another surface of said silicon substrate and having internal stress for flattening warping of said silicon substrate due to at least compressive stress of said first silicon oxide film.

2. A mask as set forth in claim 1, wherein said stress controlling layer comprises internal stress for flattening warping of said silicon substrate due to compressive stress of said first silicon oxide film and gravity.

3. A mask as set forth in claim 1, wherein said stress controlling layer includes a second silicon oxide film.

4. A mask as set forth in claim 3, wherein said stress controlling layer comprises said second silicon oxide film formed at the same step of forming said first silicon oxide film and having substantially the same thickness.

5. A method of producing a mask comprising the steps of:

   forming a single crystal silicon layer at one surface of a silicon substrate via a first silicon oxide film;
   forming a stress controlling layer at another surface of said silicon substrate having internal stress for flattening warping of said silicon substrate due to at least compressive stress of said first silicon oxide film;
   removing said stress controlling layer in any region for forming a substrate aperture;
   forming at least one substrate aperture at a portion of said silicon substrate with maintaining the stress controlling layer other than at any region for forming said substrate aperture;
   removing said first silicon oxide film on said substrate aperture; and
   forming at least one aperture at a portion of said single crystal silicon layer on said substrate aperture for passing an exposure beam.

6. A method of producing a mask as set forth in claim 5, wherein said step of forming said single crystal silicon layer and said step of forming said stress controlling layer comprise the steps of:

   forming a porous layer at one surface of another silicon substrate constituted by a bond substrate;
   forming said single crystal silicon layer on said porous layer thinner than said silicon substrate;
   oxidizing the entire surface of said silicon substrate to form said first silicon oxide film at one surface of said silicon substrate and form a second silicon oxide film for forming said stress controlling layer at another surface of said silicon substrate and having substantially the same thickness as said first silicon oxide film;
   bonding said first silicon oxide film formed on said silicon substrate and said single crystal silicon layer formed on said bond substrate via said porous layer;
   dividing said porous layer into said silicon substrate side and said bond substrate side; and
   removing said porous layer of said silicon substrate side.

7. A method of producing a mask as set forth in claim 6, further comprising the step of oxidizing said single crystal silicon layer to form a third silicon oxide film on the surface of said single crystal silicon layer before bonding said first silicon oxide film and said single crystal silicon layer; wherein
   in the step of bonding said first silicon oxide film and said single crystal silicon layer, said first silicon oxide film and said third silicon oxide film are bonded.

8.  A method of producing a mask as set forth in claim 5, wherein said step of forming said single crystal silicon layer and said step of forming said stress controlling layer comprise the steps of:

    oxidizing the entire surface of said silicon substrate to form said first silicon oxide film at one surface of said silicon substrate and form a second silicon oxide film for forming said stress controlling layer at another surface of said silicon substrate and having substantially the same thickness of said first silicon oxide film;
    implanting hydrogen ions at another silicon substrate constituted by a bond substrate to a predetermined depth less than the thickness of said silicon substrate;
    bonding said bond substrate on said silicon substrate via said first silicon oxide film; and
    fracturing said bond substrate at a position of the highest concentration of hydrogen by heating to form said single crystal silicon layer formed by said bond substrate.

9.  A method of producing a mask as set forth in claim 5, wherein said step of forming said single crystal silicon layer and said step of forming said stress controlling layer comprise the steps of:

    oxidizing the entire surface of said silicon substrate to form said first silicon oxide film at one surface of said silicon substrate and form a second silicon oxide film for forming said stress controlling layer at another surface of said silicon substrate and having substantially the same thickness of said first silicon oxide film;
    bonding another silicon substrate constituted by a bond substrate on said silicon substrate via said first silicon oxide film; and
    reducing the thickness of said bond substrate from said silicon substrate to form said single crystal silicon layer formed by said bond substrate.

10. A method of producing a mask as set forth in claim 9, wherein said step of reducing the thickness of said bond substrate from said silicon substrate comprises a step of grinding the surface of said bond substrate not contacting said first silicon oxide film.

11. A method of producing a mask as set forth in claim 9, wherein said step of reducing the thickness of said bond substrate from said silicon substrate comprises a step of polishing the surface of said bond substrate not contacting said first silicon oxide film.

12. A method of producing a mask as set forth in claim 5, wherein said step of forming said single crystal silicon layer comprises the steps of:

    implanting oxygen ions at said one surface of said silicon substrate down to a predetermined depth and
    forming said first silicon oxide film at a position of highest concentration of oxygen of said silicon substrate by heating and forming said single crystal silicon layer at said one surface of said silicon substrate.

13. A method of producing a mask as set forth in claim 12, wherein in said step of forming said stress controlling layer, said stress controlling layer is formed, said stress controlling layer having internal stress for flattening the warping of said silicon substrate due to compressive stress of said first silicon oxide film and gravity.

14. A method of producing a mask as set forth in claim 5, wherein said step of forming said stress controlling layer comprises the steps of:

    forming a protective film on said single crystal silicon layer after forming said single crystal silicon layer;
    oxidizing the entire exposed surface of said silicon substrate to form a second silicon oxide film as said stress controlling layer; and
    removing said protective film.

15. A method of producing a mask as set forth in claim 14, in said step of forming said stress controlling layer, said stress controlling layer is formed, said stress controlling layer having internal stress for flattening the warping of said silicon substrate due to compressive stress of said first silicon oxide film and gravity.

16. A method of producing a mask as set forth in claim 5, wherein said step of forming said stress controlling layer comprises the step of depositing said stress controlling layer.

17. A method of producing a mask as set forth in claim 16, in said step of forming said stress controlling layer, said stress controlling layer is formed, said stress controlling layer having internal stress for flattening the warping of said silicon substrate due to compressive stress of said first silicon oxide film and gravity.

18. A method of producing a mask as set forth in claim 5, wherein said step of forming a stress controlling layer comprises the steps of:

oxidizing the entire exposed surface of said silicon substrate to form a second silicon oxide film as said stress controlling layer and form a third silicon oxide film on the surface of said single crystal silicon layer after forming said single crystal silicon layer;

forming a protective film on said second silicon oxide layer;

removing said third silicon oxide by etching; and

removing said protective film.

19. A method of producing a mask as set forth in claim 18, in said step of forming said stress controlling layer, said stress controlling layer is formed, said stress controlling layer having internal stress for flattening the warping of said silicon substrate due to compressive stress of said first silicon oxide film and gravity.

20. A method of producing a mask comprising the steps of:

forming a single crystal silicon layer at one surface of a silicon substrate via a first silicon oxide film,

oxidizing the entire exposed surface of said silicon substrate to form a second silicon oxide film as a stress controlling layer having internal stress for flattening warping of said silicon substrate due to at least compressive stress of said first silicon oxide film and form a third silicon oxide film on the surface of said single crystal silicon layer;

removing said stress controlling layer in any region for forming a substrate aperture;

forming at least one substrate aperture at a portion of said silicon substrate with maintaining said stress controlling layer other than at any region for forming said substrate aperture;

removing said third silicon oxide film and said first silicon oxide substrate on said substrate aperture; and

forming at least one aperture at a portion of said single crystal silicon layer on said substrate aperture for passing an exposure beam.

21. A method of producing a mask as set forth in claim 20, in said step of forming said stress controlling layer, said stress controlling layer is formed, said stress controlling layer having internal stress for flattening the warping of said silicon substrate due to compressive stress of said first silicon oxide film and gravity.

22. A mask blank comprising:

a silicon substrate;

a first silicon oxide film formed at one surface of said silicon substrate;

a single crystal silicon layer formed on said first silicon oxide film; and

a stress controlling layer formed at another surface of said silicon substrate and having internal stress for flattening warping of said silicon substrate due to at least compressive stress of said first silicon oxide film.

23. A method of producing a mask blank as set forth in claim 22, wherein said stress controlling layer comprises internal stress for flattening warping of said silicon substrate due to compressive stress of said first silicon oxide film and gravity.

24. A method of producing a mask blank comprising the steps of:

oxidizing the entire surface of a silicon substrate to form a first silicon oxide film at one surface of said silicon substrate and to form a second silicon oxide film as a stress controlling layer at another surface of said silicon substrate and having internal stress for flattening warping of said silicon substrate due to compressive stress of said first silicon oxide film and having substantially the same thickness as said first silicon oxide film;

forming a porous layer at one surface of another silicon substrate constituted by a bond substrate;

forming a single crystal silicon layer on said porous layer thinner than said silicon substrate;

bonding said first silicon oxide film and said single crystal silicon layer formed on said bond substrate via said porous layer;

dividing said porous layer into said silicon substrate side and said bond substrate side; and

removing said porous layer of said silicon substrate side.

25. A method of producing a mask blank comprising the steps of:

oxidizing the entire surface of a silicon substrate to form a first silicon oxide film at one surface of said silicon substrate and to form a second silicon oxide film as a stress controlling layer at another surface of said silicon substrate having internal stress for flattening warping of said silicon substrate due to compressive stress of said first silicon oxide film and having substantially the same thickness as said first silicon oxide film;

implanting hydrogen ions in another silicon substrate constituted by a bond substrate down to a predetermined depth less than the thickness of said silicon substrate;
bonding said bond substrate on said silicon substrate via said first silicon oxide film; and fracturing said bond substrate at a position of the highest concentration of hydrogen by heating to form a single crystal silicon layer formed by said bond substrate.

26. A method of producing a mask blank comprising the steps of:

oxidizing the entire surface of a silicon substrate to form a first silicon oxide film at one surface of said silicon substrate and to form a second silicon oxide film as a stress controlling layer at another surface of said silicon substrate having internal stress for flattening warping of said silicon substrate due to compressive stress of said first silicon oxide film and having substantially the same thickness as said first silicon oxide film;
bonding another silicon substrate constituted by a bond substrate on said silicon substrate via said first silicon oxide film; and reducing the thickness of said bond substrate from said silicon substrate to form a single crystal silicon layer formed by said bond substrate.

27. A method of producing a mask blank comprising the steps of:

forming a stress controlling layer at one surface of a silicon substrate having internal stress for flattening warping of said silicon substrate due to at least compressive stress of a first silicon oxide film;
implanting oxygen ions near another surface of said silicon substrate down to a predetermined depth; and
forming the first silicon oxide film at a position of a highest concentration of oxygen of said silicon substrate by heating and forming a single crystal silicon layer at another surface of said silicon substrate.

28. A method of producing a mask blank as set forth in claim 27, wherein in said step of forming said stress controlling layer, said stress controlling layer is formed, which said stress controlling layer having internal stress for flattening warping of said silicon substrate due to compressive stress of said first silicon oxide film and gravity.

29. A method of producing a mask blank comprising the steps of:

forming a single crystal silicon layer at one surface of a silicon substrate via a first silicon oxide film and
forming a stress controlling layer at another surface of said silicon substrate having internal stress for flattening warping of said silicon substrate due to at least compressive stress of said first silicon oxide film.

30. A method of producing a mask blank as set forth in claim 29, wherein in said step of forming said stress controlling layer, said stress controlling layer is formed, which said stress controlling layer having internal stress for flattening warping of said silicon substrate due to compressive stress of said first silicon oxide film and gravity.

31. A method of producing a mask blank as set forth in claim 29, wherein said step of forming said stress controlling layer comprises the steps of:

forming a protective film on a single crystal silicon layer after forming said first silicon oxide film and said single crystal silicon layer;
oxidizing the entire exposed surface of said silicon substrate to form a second silicon oxide film as said stress controlling layer; and removing said protective film.

32. A method of producing a mask blank as set forth in claim 29, wherein said step of forming said stress controlling layer comprises the step of depositing said stress controlling layer at another surface after forming said first silicon oxide film and said single crystal silicon layer.

33. A method of producing a mask blank as set forth in claim 29, wherein said step of forming said stress controlling layer comprises the steps of:

oxidizing the entire exposed surface of said silicon substrate to form a second silicon oxide film as said stress controlling layer at another surface of said silicon substrate and to form a third silicon oxide film at the surface of said single crystal silicon layer;
forming a protective film on said second silicon oxide film;
removing said third silicon oxide film by etching; and
removing said protective film.

# FIG. 1

# FIG. 2

FIG. 3A

111

112
113

FIG. 3B

112
113
111

FIG. 3C

112
113
111

FIG. 3D

114 (112)
115 (113)
111

FIG. 4A

113

112

FIG. 4B

IMPLANTING H⁺ ION

111

112   113

FIG. 4C

113

112

111

FIG. 4D

112a

111

FIG. 4E

114 (112)

115 (113)

111

FIG. 5A

121
112

FIG. 5B

122
121
112

FIG. 5C

123
122
121
112

124
111

FIG. 5D

112
121
122
123,124
111

FIG. 5E

~112
~121

~121
~122
~115 (123,124)

~111

FIG. 5F

~114 (122)
~115 (123,124)

~111

FIG. 6

IMPLANTING O⁺ ION

~114
~115

~126

# FIG. 7

EP 1 475 664 A2

# FIG. 8

Graph: X-axis "BOX LAYER THICKNESS (nm)" (0, 200, 400, 600); Y-axis "MAXIMUM WARPING (μm)" (0, 20, 40, 60); curve labeled A.

FIG. 9A

FIG. 9B

FIG. 9C

FIG. 9D

FIG. 9E

FIG. 9F

IMPLANTING BORON ION

**FIG. 10A**

**FIG. 10B**

**FIG. 10C**

**FIG. 10D**

FIG. 10E

FIG. 10F

FIG. 10G

FIG. 10H

IMPLANTING H⁺ ION

FIG. 11A

2    6    1    3

6

FIG. 11B

2    1    3

FIG. 11C

2    1    3

5 (3)    4 (2)

FIG. 11D

1    3

FIG. 12A

FIG. 12B

FIG. 12C

FIG. 12D

FIG. 13A

~16

~17

FIG. 13B

IMPLANTING O⁺ ION

~4

~5

~17

FIG. 14A

31
4
5
1

FIG. 14B

31
4
1
32

FIG. 14C

5
4
1
32

# FIG. 15

FIG. 16A

FIG. 16B

FIG. 16C

FIG. 16D

IMPLANTING BORON ION

FIG. 17A

4
5  } 33
1

FIG. 17B

35a
4
5  } 33
1
35b

FIG. 17C

36
35b
1
5
4
35a

FIG. 17D

36
35b
23    24    1
5
4
35a

FIG. 17E

36
35b
25    1
5
4

FIG. 17F

26
4
5
1
35b

FIG. 17G

25
4
5
23    24    1
35b